# EUROPÄISCHE PATENTSCHRIFT

(11) **EP 0 905 169 B1**
(45) Veröffentlichungstag und Bekanntmachung des Hinweises auf die Patenterteilung: **02.04.2008**
(21) Anmeldenummer: 98117333.9
(22) Anmeldetag: 12.09.1998
(51) Int. Cl.: C08G 73/22, C08G 75/32, G03F 7/038

(54) **Polybenzoxazol- und Polybenzothiazol-Vorstufen**
Precursors of polybenzoxazoles and polybenzothiazoles
Précurseurs de polybenzoxazoles et polybenzothiazoles

(30) Priorität: 24.09.1997 DE 19742132
(43) Veröffentlichungstag der Anmeldung: 31.03.1999
(73) Patentinhaber: Infineon Technologies AG, 81669 München (DE)
(72) Erfinder: Sezi, Recai Dr., 91341 Röttenbach (DE); Schmid, Günter Dr., 91056 Erlagen (DE); Keitmann, Michael, 91074 Herzogenaurach (DE)
(74) Vertreter: Epping - Hermann - Fischer

(56) Entgegenhaltungen:
- EP-A- 0 733 665
- DE-A- 2 647 004
- DE-A- 19 537 893
- FR-A- 2 595 362
- CHEMICAL ABSTRACTS, vol. 106, no. 10, 9. März 1987 (1987-03-09) Columbus, Ohio, US; abstract no. 67818y, IGNATENKO ET AL.: "BIS(3-AMINO-4-HYDROXYPHENOXY)PERFLUOROARY LENES AS MONOMERS FOR PRODUCING POLYBENZOXAZOLES WITH HIGHER THERMAL AND HYDROLYTIC STABILITY" XP002088350 & SU 1 205 518 A
- CHEMICAL ABSTRACTS, Bd. 120, Nr. 14, 4. April 1994 (1994-04-04), Columbus, Ohio, US; abstract no.: 164950G, WINZELER ET AL: "The syntehsis of 6F bis(o-aminophenol) monomers by a nucleophilic substitution reaction" XP002088351

## Beschreibung

Die Erfindung betrifft neue Polybenzoxazol- und Polybenzothiazol-Vorstufen sowie diese Vorstufen enthaltende Resistlösungen.

In der Mikroelektronik werden hochwärmebeständige Polymere als Schutz- und Isolierschichten benötigt. Derartige Polymere können als Dielektrikum zwischen zwei Metallebenen eingesetzt werden, beispielsweise bei Multi-Chip-Modulen sowie Speicher- und Logikchips, oder als Pufferschicht ("Buffercoat") zwischen dem Chip und seinem Gehäuse. Einige dieser Polymeren, beispielsweise Vorstufen aromatischer Polyimide (PI) und Polybenzoxazole (PBO), zeigen eine gute Löslichkeit in organischen Lösemitteln sowie gute Filmbildungseigenschaften und können mittels kostengünstiger Schleudertechnik auf die elektronischen Bauteile aufgebracht werden. Die Vorstufen werden dann durch eine Temperaturbehandlung cyclisiert, d.h. in das entsprechende Polymer übergeführt, und erhalten damit ihre endgültigen Eigenschaften.

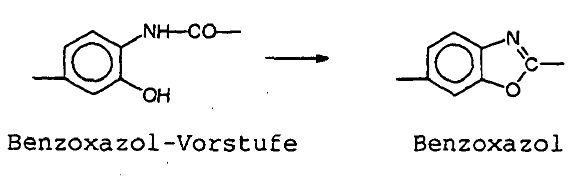

Bei der Cyclisierung verschwinden die polaren, hydrophilen Gruppierungen der PBO-Vorstufe (OH, NH und CO), die sonst die dielektrischen Eigenschaften und die Wasseraufnahme negativ beeinflussen würden. Dies ist beispielsweise ein wesentlicher Vorteil von Polybenzoxazolen gegenüber Polyimiden und insbesondere gegenüber Hydroxypolyimiden. Die Cyclisierung ist aber nicht nur für die guten dielektrischen Eigenschaften und die geringe Wasseraufnahme des Endproduktes wichtig, sondern auch für dessen hohe Temperaturstabilität.

Die Anforderungen an das cyclisierte Endprodukt sind sehr hoch. So ist beispielsweise neben einer möglichst niedrigen Dielektrizitätskonstante und einer hohen thermischen Stabilität insbesondere eine geringe Feuchteaufnahme erforderlich. Die aufgenommene Feuchte beeinträchtigt nämlich nicht nur die elektrischen Eigenschaften, sondern kann auch die Korrosion der metallischen Leiterbahnen fördern oder bei hohen Temperaturen zu Blasenbildungen und Abplatzungen führen.

Polyimide und Polybenzoxazole haben gegenüber vielen anderen hochtemperaturstabilen Polymeren folgende Vorteile:
- Sie können - im Vergleich zum cyclisierten Endprodukt - als lösliche Vorstufe auf ein Substrat aufgebracht und anschließend cyclisiert werden, wobei die Löslichkeit und damit die Sensibilität gegenüber Lösemitteln und anderen Prozeßchemikalien stark abnimmt. Aus diesem Grunde ist beispielsweise die Verarbeitung von vorcyclisierten Polybenzoxazolen schwierig.
- Durch den Zusatz von geeigneten photoaktiven Komponenten zu den Vorstufen können photosensitive Zusammensetzungen hergestellt werden, wodurch eine kostengünstige direkte Strukturierung des Dielektrikums möglich wird. Polybenzoxazole haben gegenüber Polyimiden den weiteren Vorteil, daß sie im positiven Modus strukturierbar und wäßrig-alkalisch entwickelbar sind (siehe EP 0 023 662 B1, EP 0 264 678 B1 und EP 0 291 779 B1). Hierzu müssen die verwendeten PBO-Vorstufen im - vorzugsweise metallionenfreien - alkalischen Entwickler löslich sein.
- Benzocyclobuten (BCB), das in ähnlicher Weise verarbeitet und negativ strukturiert werden kann, hat eine wesentlich geringere Temperaturstabilität als Polyimid und Polybenzoxazol.

Eine weitere, im Zusammenhang mit der kostengünstigen Herstellung von mikroelektronischen Bauteilen wichtige Anforderung ist das Planarisierungvermögen des Dielektrikums. Bei der Herstellung solcher Bauteile entstehen nämlich während der Aufbringung verschiedener Schichten Höhenunterschiede, die eine weitere Prozessierung, beispielsweise die lithographische Erzeugung feiner Strukturen, erschweren. Auf planarisiertem Untergrund können dagegen photolithographische Prozesse mit besserer Maßhaltigkeit und größeren Prozeßtoleranzen durchgeführt werden. Durch die Verwendung eines gut planarisierenden Dielektrikums können bei der Herstellung der Bauteile kostenintensive Schleifprozeduren (Chemical Mechanical Polishing; CMP) vermieden werden.

Alkalilösliche PBO-Vorstufen, die zur Herstellung von photosensitiven Zusammensetzungen geeignet sind, sind beispielsweise aus EP 0 023 662 B1, EP 0 264 678 B1, EP 0 291 779 B1 und DE 37 16 629 C2 bekannt; diese Vorstufen lassen sich auf dem Substrat cyclisieren (siehe dazu EP 0 291 778 B1). Die bekannten Polymeren zeigen jedoch nach der Cyclisierung (Überführung in das Polybenzoxazol) eine relativ hohe Feuchteaufnahme, beispielsweise 1,7 % (siehe EP 0 291 778 B1). Hinweise auf das Planarisierungsvermögen der hergestellten Polymeren gibt es nicht.

Aufgabe der Erfindung ist es, Polybenzoxazol- und Polybenzothiazol-Vorstufen bereitzustellen, die sowohl in organischen Lösemitteln als auch in metallionenfreien wäßrig-alkalischen Entwicklern gut löslich sind, sich gut für photosensitive Zusammensetzungen eignen und mittels Schleudertechnik verarbeitet werden können. Die Vorstufen sollen ferner auf Substraten problemlos cyclisierbar sein und nach der Cyclisierung - neben einer hohen Temperaturstabilität - insbesondere eine sehr geringe Feuchteaufnahme und einen hohen Planarisierungsgrad aufweisen.

Dies wird erfindungsgemäß durch Polybenzoxazol- und Polybenzothiazol-Vorstufen erreicht, die folgende Partialstruktur enthalten: 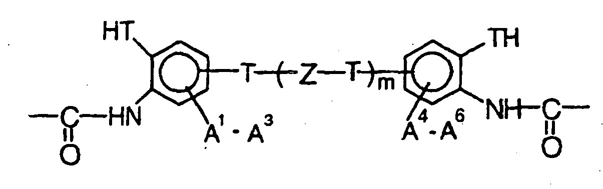 dabei gilt folgendes:
A¹ bis A⁶ sind - unabhängig voneinander - H, F, CH₃, CF₃, OCH₃, OCF₃, CH₂CH₃, CF₂CF₃, OCH₂CH₃ oder OCF₂CF₃;
T ist O oder S, und m ist 0 oder 1;
Z ist einer der folgenden Reste: 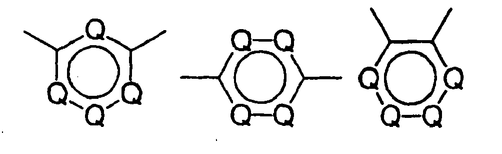 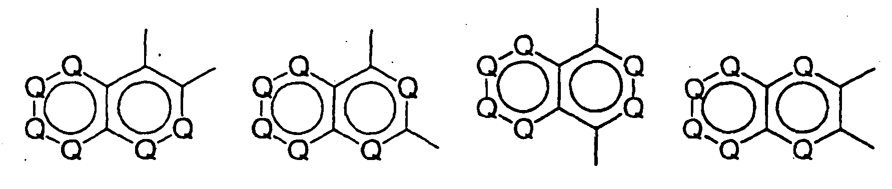 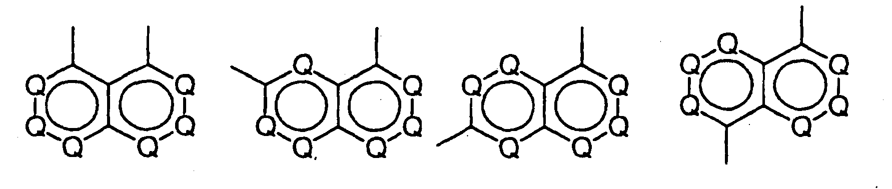 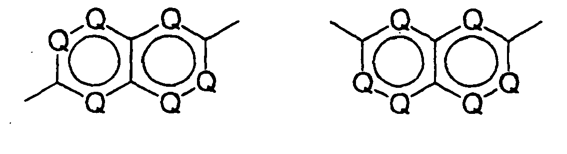 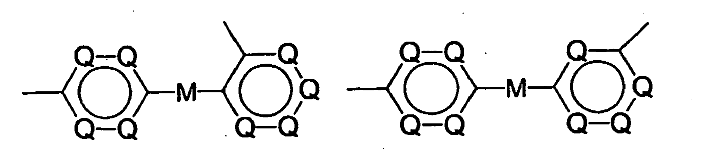 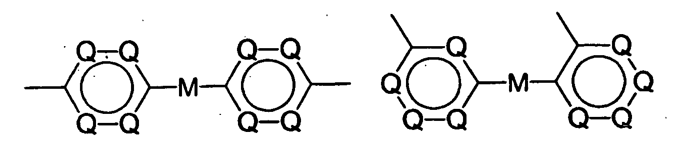 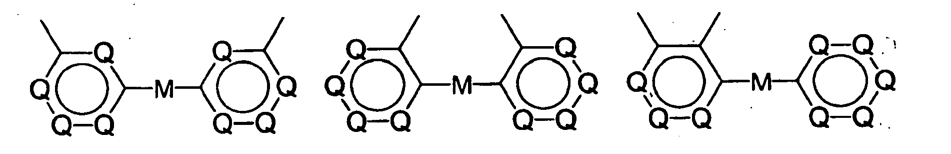 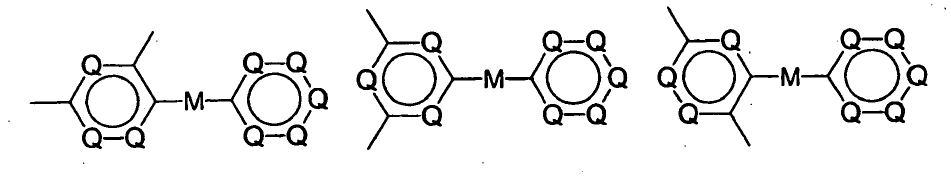 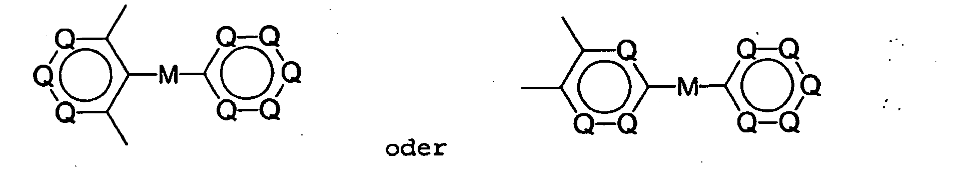 mit
   - Q =: C-A oder N, mit A = H, F, (CH₂)ₚCH₃, (CF₂)pCF₃, O(CH₂)ₚCH₃, O(CF₂)ₚCF₃, CO(CH₂)ₚCH₃, CO(CF₂)ₚCF₃ mit p = 0 bis 8 (Kette linear oder verzweigt), OC(CH₃)₃, OC(CF₃)₃, C₆H₅, C₆F₅, OC₆H₅, OC₆F₅, Cyclopentyl, Perfluorcyclopentyl, Cyclohexyl oder Perfluorcyclohexyl,
   wobei in den isolierten aromatischen Ringen maximal 3 N-Atome pro Ring vorhanden sein dürfen und nur 2 N-Atome benachbart sein können und in den anellierten Ringsystemen maximal 2 N-Atome pro Ring vorhanden sein dürfen,
   - M =: eine Einfachbindung, geradkettige Alkylen-Gruppe CH(CH₃), CH(CF₃), CF(CH₃), CF(CF₃), CH(C₆H₅), CH(C₆F₅), CF(C₆H₅), CF(C₆F₅), C(CH₃)(C₆H₅), C(CH₃)(C₆F₅), C(CF₃)(C₆H₅), C(CF₃)(C₆F₅), C(C₆H₅)₂, C(C₆F₅)₂, CO, SO₂, 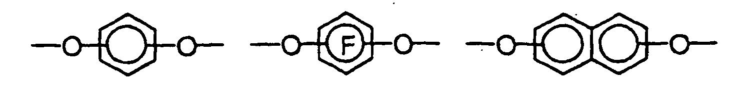 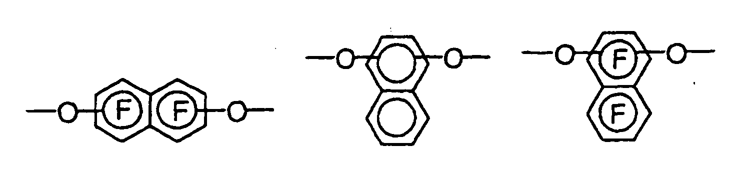 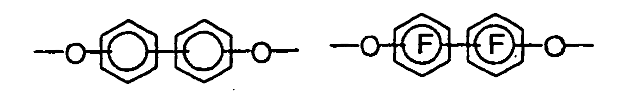 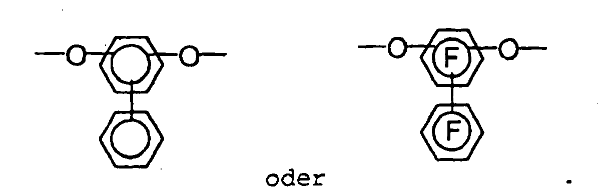
mit der Maßgabe, daß bei Z = Phenylen (dies sind die ersten drei der vorstehend bei Z aufgeführten Reste mit Q = C-A) oder m = 0 mindestens einer der Reste A¹ bis A⁶ ≠ H sein muß und bei Z = 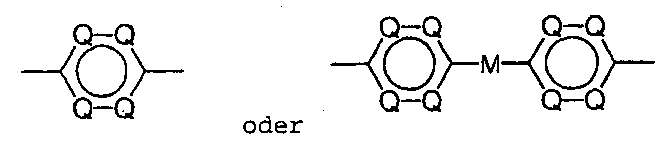 wenn Q die Bedeutung C-F hat und M eine Einfachbindung ist, sich die NH-CO-Gruppierungen der Polybenzoxazol-Partialstruktur in o- oder p-Stellung zur O-Brücke befinden müssen.

Polymer-Vorstufen der vorstehend angegebenen Struktur werden durch Umsetzung von entsprechenden Bis-o-aminophenolen bzw. Bis-o-aminothiophenolen mit einer oder mehreren geeigneten Dicarbonsäuren oder Dicarbonsäurederivaten, insbesondere aktive Ester und Chloride, hergestellt. Dabei werden das Bis-o-aminophenol bzw. das Bis-o-aminothiophenol und die Dicarbonsäure oder das Dicarbonsäurederivat in einem organischen Lösemittel bei einer Temperatur von -20 bis 150°C zur Reaktion gebracht, das Polymer wird dann durch Zutropfen der Reaktionslösung zu einem geeigneten Fällungsmittel ausgefällt. Das ausgefallene Polymer ist bereits nach der Filtration und der Trocknung einsatzbereit. Vor dem Ausfällen des Polymers können dessen Aminoendgruppen mit einem Dicarbonsäureanhydrid verkappt, d.h. blockiert werden.

Die zur Herstellung der Polybenzoxazol- und Polybenzothiazol-Vorstufen nach der Erfindung eingesetzten Bis-o-aminophenole und Bis-o-aminothiophenole weisen folgende Struktur auf:

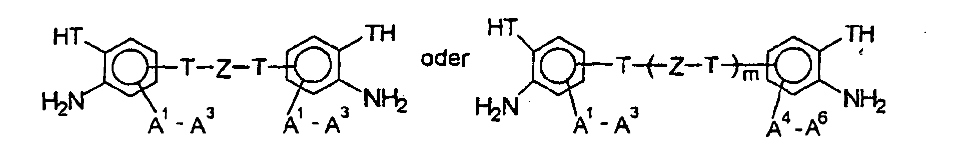

Diese Vorstufen sind Gegenstand folgender gleichzeitig eingereichter deutscher Patentanmeldungen:
- Akt.Z. 197 42 195.4 - "Bis-o-amino(thio)phenole und deren Herstellung" (GR 97 P 3688);
- Akt.Z. 197 42 196.2 - "Bis-o-amino(thio)phenole und deren Herstellung" (GR 97 P 3684).

Im übrigen bedeutet die Charakterisierung "A¹-A³" und "A⁴-A⁶" in den Strukturformeln, daß die Aminophenylgruppen Reste A¹, A² und A³ bzw. A⁴, A⁵ und A⁶ aufweisen.

Beispiele für derartige Bis-o-Aminophenole sind:
4,4'-Bis(4-amino-3-hydroxy-phenoxy)-octafluorbiphenyl 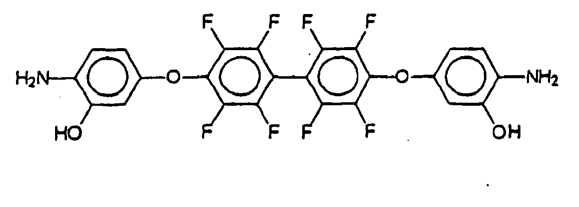
4,4'-Bis(4-amino-3-hydroxy-phenoxy)-octafluorbenzophenon 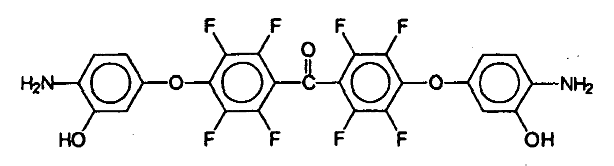
2,4-Bis(4-amino-3-hydroxy-phenoxy)-trifluorpyridin 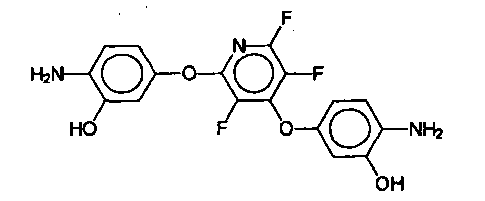
2,4-Bis(4-amino-3-hydroxy-phenoxy)-1-trifluormethyl-3,5,6-trifluorbenzol 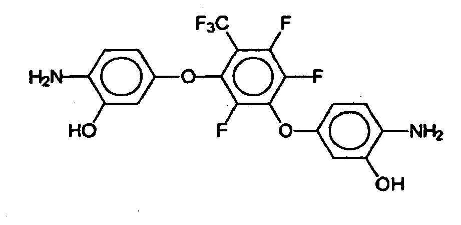
1,4-Bis(4-amino-3-hydroxy-2,5,6-trifluor-phenox.y)-tetrafluorbenzol 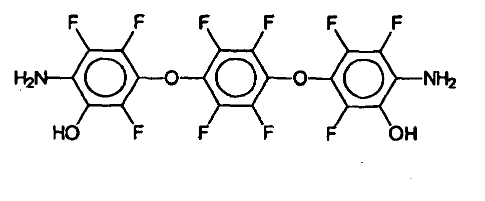
4,6-Bis(4-amino-3-hydroxy-2,5,6-trifluor-phenoxy)-pyrimidin 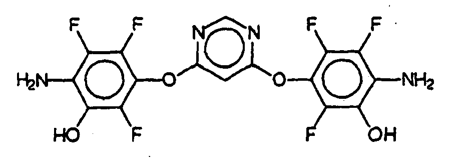
4,4'-Bis(4-amino-3-hydroxy-2,5,6-trifluor-phenoxy)-octafluorbiphenyl

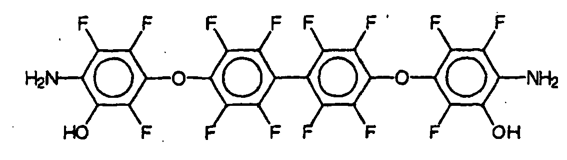

Für die Herstellung der Vorstufen sind Dicarbonsäuren wie 4,4'-Oxybisbenzoesäure, 2,2-Bis(4-carboxyphenyl)-perfluorpropan und Isophthalsäure besonders geeignet. Prinzipiell können aber alle Dicarbonsäuren verwendet werden, die bis zu drei aromatische Kerne haben. Werden bei der Polymerisation Dicarbonsäurechloride verwendet, so ist der Einsatz eines basischen Säurefängers von Vorteil. Als derartiger Säurefänger dient vorzugsweise Pyridin, Triethylamin, Diazabicyclooctan und Polyvinylpyridin. Es können aber auch andere basische Säurefänger eingesetzt werden, wobei insbesondere solche bevorzugt werden, die im für die Synthese verwendeten Lösemittel, beispielsweise N-Methylpyrrolidon, und in Wasser oder Wasser/Alkohol-Gemischen (Fällungsmittel) gut löslich sind, und auch solche, die im Lösemittel vollkommen unlöslich sind, beispielsweise vernetztes Polyvinylpyridin.

Besonders geeignete Lösemittel für die Polymersynthese sind Dimethylacetamid, γ-Butyrolacton und N-Methylpyrrolidon. Prinzipiell kann jedoch jedes Lösemittel verwendet werden, in dem die Ausgangskomponenten gut löslich sind. Besonders geeignete Fällungsmittel sind Wasser und Gemische von Wasser mit verschiedenen Alkoholen, beispielsweise Ethanol und Isopropanol.

Die Polymer-Vorstufen nach der Erfindung sind in vielen organischen Lösemitteln, wie Aceton, Cyclohexanon, Diethylenglykolmono- bzw. -diethylether, N-Methylpyrrolidon, γ-Butyrolacton, Ethyllactat, Tetrahydrofuran und Essigsäureethylester, sowie in metallionenfreien wäßrig-alkalischen Entwicklern gut löslich und lassen sich mittels Schleudertechnik problemlos verarbeiten. Nach der Cyclisierung auf dem Substrat zeigen die dabei erhaltenen Polybenzoxazole und Polybenzothiazole eine sehr geringe Feuchteaufnahme, einen hohen Planarisierungsgrad und eine hohe Temperaturstabilität.

Die Polymer-Vorstufen nach der Erfindung sind mit Diazoketonen verträglich und eignen sich deshalb vorteilhaft für Photoresistlösungen, die - gelöst in einem Lösemittel - eine Polybenzoxazol- oder Polybenzothiazol-Vorstufe und eine photoaktive Komponente auf Diazoketonbasis aufweisen. Derartige photoaktive Zusammensetzungen zeigen überraschenderweise eine hohe Auflösung und eine sehr gute Filmqualität. In den Photoresistlösungen liegt das Gewichtsverhältnis von Polybenzoxazol- bzw. Polybenzothiazol-Vorstufe zu Diazochinon vorteilhaft zwischen 1:20 und 20:1, vorzugsweise zwischen 1:10 und 10:1.

Anhand von Ausführungsbeispielen soll die Erfindung noch näher erläutert werden.

### Beispiel 1

### Herstellung eines Bis-o-aminophenols: 4,4'-Bis(4-amino-3-hydroxy-phenoxy)-octafluorbiphenyl

24,5 g 5-Hydroxy-2-nitro-phenylbenzylether (0,1 mol) und 16,7 g Decafluorbiphenyl (0,05 mol) werden in einem Dreihalskolben mit Rückflußkühler, Rührer und Stickstoffzuleitung in 270 ml trockenem Dimethylsulfoxid gelöst. Nach der Zugabe von 30 g Kaliumcarbonat (0,22 mol) wird die Lösung in einem regelbaren Ölbad 4 h auf 100°C erhitzt, danach läßt man die Reaktionslösung auf Raumtemperatur abkühlen und filtriert den Rückstand über ein Faltenfilter ab. Die Lösung wird dann zu 500 ml Wasser gegeben und mit konzentrierter Salzäure bis zur sauren Reaktion versetzt. Das dabei ausfallende gelbbeige Reaktionsprodukt wird über einen Büchnertrichter abfiltriert, dreimal mit Wasser gewaschen und danach in einem Gemisch von Methanol und Methylenchlorid (Volumenverhältnis 1:1) umkristallisiert. Anschließend wird das Reaktionsprodukt in einem Vakuumschrank 48 h unter Stickstoff bei 40°C/10 mbar getrocknet.

72 g des auf diese Weise hergestellten 4,4'-Bis-(4-nitro-3-benzyloxy-phenoxy)-octafluorbiphenyl (0,09 mol) werden in 600 ml eines Gemisches von Tetrahydrofuran und Essigsäureethylester (Volumenverhältnis 1:1) gelöst, und zu der Lösung werden 7 g Pd/C (Palladium/Kohlenstoff) gegeben. Dann wird bei Raumtemperatur in einem Autoklaven unter starkem Rühren mit Wasserstoff bei einem Druck von 1 bar hydriert; nach 7 Tagen wird die Reaktion beendet. Die gelbbeige Lösung wird in einem Rotationsverdampfer auf die Hälfte eingeengt und über Nacht bei Raumtemperatur stehengelassen; dabei fällt das Reaktionsprodukt kristallin aus. Anschließend wird das Reaktionsprodukt in einem Vakuumschrank 48 h unter Stickstoff bei 40°C/10 mbar getrocknet.

### Beispiel 2

### Herstellung einer PBO-Vorstufe

54,4 g entsprechend Beispiel 1 hergestelltes 4,4'-Bis-(4-amino-3-hydroxy-phenoxy)-octafluorbiphenyl (0,1 mol), werden in 300 ml destilliertem N-Methylpyrrolidon gelöst. Zu dieser Lösung wird bei 10°C unter Rühren eine Lösung von 29,5 g Oxybisbenzoesäurechlorid (0,1 mol) in 150 ml γ-Butyrolacton getropft und die Reaktionslösung 16 h gerührt. Danach wird zur Reaktionslösung bei Raumtemperatur langsam eine Lösung von 17,4 g Pyridin (0,22 mol) in 80 ml γ-Butyrolacton getropft und die erhaltene Reaktionslösung 2 h bei Raumtemperatur gerührt. Das entstandene Polymer wird durch Zutropfen der Reaktionslösung zu einem Gemisch von Isopropanol und Wasser (1:3) ausgefällt, dreimal mit frischem Fällungsmittel gewaschen und in einem Vakuumofen 72 h bei 50°C/10 mbar getrocknet.

Die auf diese Weise hergestellte PBO-Vorstufe ist in Lösemitteln wie N-Methylpyrrolidon, γ-Butyrolacton, Aceton, Tetrahydrofuran, Cyclopentanon, Diethylenglykolmonoethylether, Ethyllactat und Ethanol sowie in kommerziell erhältlichen metallionenfreien wäßrig-alkalischen Entwicklern, wie NMD-W (Tokyo Ohka), gut löslich.

### Beispiel 3

### Bestimmung der Feuchteaufnahme

4 g der PBO-Vorstufe nach Beispiel 2 werden in 12 g destilliertem N-Methylpyrrolidon gelöst. Die Lösung wird mittels einer mit einem Vorfilter versehenen Plastikspritze auf ein Substrat in Form einer gereinigten, getrockneten und genau abgewogenen Siliziumscheibe (Wafer) aufgetragen und in einer Schleuderapparatur (Typ ST 146, Convac) geschleudert. Der auf dem Substrat entstandene Film wird zunächst auf einer Heizplatte bei 120°C vorgetrocknet und anschließend - für die Cyclisierung (auf dem Substrat) - in einem programmierbaren Laborofen ("Sirius Junior", LP-Thermtech AG) unter Stickstoff auf 350°C aufgeheizt und bei dieser Temperatur 1 h getempert; dann wird abgekühlt. Die Aufheiz- und Abkühlgeschwindigkeit beträgt jeweils 5°C/min.

Das beschichtete Substrat wird in eine tarierte Mikrowaage (Typ AT 261 Deltarange, Mettler Toledo) mit einer abgedichteten Kammer gestellt, in der sich Phosphorpentoxid als Trocknungsmittel befindet. Das nach 24 h ermittelte Gesamtgewicht beträgt 11,50864 g. Hieraus ergibt sich für das cyclisierte Polymer ein Gewicht von 0,15432 g (Gewicht der reinen Siliziumscheibe 11,35432 g). Das Phosphorpentoxid wird dann durch eine gesättigte Natriumchlorid-Lösung ersetzt und in der Kammer eine relative Feuchtigkeit (23°C) von 76 % eingestellt. Nach weiteren 24 h Lagerung erhöht sich das Gewicht des Films auf 0,15562 g. Hieraus ergibt sich eine Feuchteaufnahme von 0,84 %. Eine nicht-beschichtete Siliziumscheibe zeigt unter gleichen Bedingungen keine Feuchteaufnahme.

### Beispiel 4

### Bestimmung des Planarisierungsgrades

Das Planarisierungsvermögen von aus den Vorstufen nach der Erfindung durch Cyclisierung auf einem Substrat hergestellten Polybenzoxazolen wird an Siliziumwafern mit 1,2 µm hohen Aluminiumstrukturen (Planarisierungswafer) bestimmt. Der Planarisierungsgrad ist für die periodischen 5 µm-Strukturen (= Linien- und Grabenbreite; alternierend) angegeben. Die Bestimmung des Planarisierungsgrades erfolgt nach D.S. Soane und Z. Martynenko: "Polymers in Microelectronics - Fundamentals and Applications", Elsevier Science Publishers B.V., Amsterdam 1989, Seiten 189 bis 191.

Die PBO-Vorstufe nach Beispiel 2 wird - wie in Beispiel 3 - auf einen Planarisierungswafer (Substrat) aufgebracht und cyclisiert. Der cyclisierte Film weist eine Dicke von 2,0 µm auf; der Planarisierungsgrad beträgt 84 %.

### Beispiel 5

### Temperaturstabilität

Ein Teil des cyclisierten Polymers nach Beispiel 3 wird nach der Feuchtemessung vom Substrat abgetragen und thermogravimetrisch untersucht (Gerät STA 1500, Polymer Laboratories). Dabei wird festgestellt, daß ein Masseverlust von 1 % erst bei einer Temperatur von 480°C erreicht wird. Im Vergleich dazu ergibt sich bei bekannten Polybenzoxazolen (siehe SU 1 205 518 A) ein Masseverlust von 1 % bereits bei einer Temperatur von 420 bis 430°C.

### Beispiel 6

### Photostrukturierung

4 g der PBO-Vorstufe nach Beispiel 2 werden zusammen mit 1 g eines Diesters aus Bisphenol A und Naphthochinondiazid-5-sulfonsäure (photoaktive Komponente) in 15 g N-Methylpyrrolidon gelöst. Diese Photoresistlösung wird mittels einer mit einem Vorfilter versehenen Plastikspritze auf ein Substrat in Form einer gereinigten und getrockneten Siliziumscheibe (Wafer) aufgetragen und in einer Schleuderapparatur (Typ ST 146, Convac) geschleudert. Der auf dem Substrat entstandene Resistfilm wird zunächst auf einer Heizplatte bei 120°C vorgetrocknet und anschließend in einer Belichtungsapparatur (Typ 121, Karl Süss) durch eine Maske belichtet. Nach der Entwicklung mit einem wäßrig-alkalischen Entwickler (NMD-W, Tokyo Ohka, 1:1 mit Wasser verdünnt) und der Cyclisierung (auf dem Substrat) bei 350°C entsprechend Beispiel 3 werden hochtemperaturstabile Resiststrukturen mit einer Auflösung von 2 µm bei einer Schichtdicke von 1,7 µm erhalten.

### Beispiel 7 (Vergleichsbeispiel)

Analog zu Beispiel 2 wird eine PBO-Vorstufe hergestellt, wobei - unter sonst gleichen Bedingungen - als Bis-o-aminophenol Hexafluor-2,2-bis(3-amino-4-hydroxyphenyl)-propan (0,1 mol, d.h. 36,6 g) entsprechend EP 0 264 678 B1 eingesetzt wird. Bei dieser Vorstufe wird eine Feuchteaufnahme von 1,8 % (siehe Beispiel 3) und ein Planarisierungsgrad von 68 % (siehe Beispiel 4) ermittelt.

### Beispiel 8 (Vergleichsbeispiel)

Analog zu Beispiel 2 wird eine PBO-Vorstufe hergestellt, wobei - unter sonst gleichen Bedingungen - als Bis-o-aminophenol 3,3'-Dihydroxybenzidin (0,1 mol, d.h. 21,6 g) entsprechend EP 0 023 662 B1 eingesetzt wird. Bei dieser Vorstufe wird eine Feuchteaufnahme von 2,1 % (siehe Beispiel 3) und ein Planarisierungsgrad von 61 % (siehe Beispiel 4) ermittelt.

### Beispiel 9

### Herstellung einer PBO-Vorstufe und Bestimmung der Eigenschaften

Analog zu Beispiel 2 wird eine PBO-Vorstufe hergestellt, wobei - unter sonst gleichen Bedingungen - als Bis-o-aminophenol 4,4'-Bis(4-amino-3-hydroxy-phenoxy)-octafluorbenzophenon (0,1 mol, d.h. 57,2 g) eingesetzt wird. Das Bis-o-aminophenol wird - analog Beispiel 1 - aus 5-Hydroxy-2-nitrophenylbenzylether und Decafluorbenzophenon hergestellt.

Die erhaltene PBO-Vorstufe ist in den in Beispiel 2 aufgeführten Lösemitteln gut löslich. Bei dieser Vorstufe wird eine Feuchteaufnahme von 0,95 % (siehe Beispiel 3) und ein Planarisierungsgrad von 87 % (siehe Beispiel 4) ermittelt. Nach der entsprechend Beispiel 6 durchgeführten Photostrukturierung und Cyclisierung auf dem Substrat werden hochtemperaturstabile Resiststrukturen mit einer Auflösung von 2 µm bei einer Schichtdicke von 1,9 µm erhalten.

### Beispiel 10

### Herstellung einer PBO-Vorstufe und Bestimmung der Eigenschaften

Analog zu Beispiel 2 wird eine PBO-Vorstufe hergestellt, wobei - unter sonst gleichen Bedingungen - als Bis-o-aminophenol 4,6-Bis(4-amino-3-hydroxy-2,5,6-trifluorphenoxy) pyrimidin (0,1 mol, d.h. 43,4 g) und als Dicarbonsäuredichlorid Isophthalsäuredichlorid (0,1 mol, d.h. 20,3 g) eingesetzt wird. Das Bis-o-aminophenol wird - analog Beispiel 1 - aus 4,6-Dihydroxypyrimidin und Pentafluor-nitrobenzol hergestellt.

Die erhaltene PBO-Vorstufe ist in den in Beispiel 2 aufgeführten Lösemitteln gut löslich. Bei dieser Vorstufe wird eine Feuchteaufnahme von 0,97 % (siehe Beispiel 3) und ein Planarisierungsgrad von 86 % (siehe Beispiel 4) ermittelt. Nach der entsprechend Beispiel 6 durchgeführten Photostrukturierung und Cyclisierung auf dem Substrat werden hochtemperaturstabile Resiststrukturen mit einer Auflösung von 2 µm bei einer Schichtdicke von 2 µm erhalten.

### Beispiel 11

### Herstellung einer PBO-Vorstufe und Bestimmung der Eigenschaften

Analog zu Beispiel 2 wird eine PBO-Vorstufe hergestellt, wobei - unter sonst gleichen Bedingungen - als Bis-o-aminophenol 1,4-Bis(4-amino-3-hydroxy-2,5,6-trifluor-phenoxy)-tetrafluorbenzol (0,1 mol, d.h. 50,4 g) und als Dicarbonsäuredichlorid Adipinsäuredichlorid (0,1 mol, d.h. 18 g) eingesetzt wird. Das Bis-o-aminophenol wird - analog Beispiel 1 - aus Tetrafluorhydrochinon und Pentafluor-nitrobenzol hergestellt.

Die erhaltene PBO-Vorstufe ist in den in Beispiel 2 aufgeführten Lösemitteln gut löslich. Bei dieser Vorstufe wird eine Feuchteaufnahme von 0,96 % (siehe Beispiel 3) und ein Planarisierungsgrad von 85 % (siehe Beispiel 4) ermittelt. Nach der entsprechend Beispiel 6 durchgeführten Photostrukturierung und Cyclisierung auf dem Substrat werden hochtemperaturstabile Resiststrukturen mit einer Auflösung von 2 µm bei einer Schichtdicke von 2,2 µm erhalten.

### Beispiel 12

### Herstellung einer PBO-Vorstufe und Bestimmung der Eigenschaften

Die in Beispiel 2 beschriebene PBO-Vorstufe ist auch auf chloridfreiem Weg herstellbar. Dazu werden 25,8 g Oxybisbenzoesäure (0,1 mol) in 200 ml N-Methylpyrrolidon gelöst und portionsweise mit 34,1 g Carbonyldiimidazol (0,21 mol) versetzt. Nachdem die Gasentwicklung (CO₂) abgeklungen ist, wird noch 2 h gerührt. Die erhaltene Suspension wird dann zu 54,4 g 4,4'-Bis(4-amino-3-hydroxy-phenoxy)-octafluorbiphenyl (0,1 mol), gelöst in 300 ml N-Methylpyrrolidon, gegeben und 40 h bei Raumtemperatur gerührt; hierbei klärt sich die Reaktionslösung wieder. Die Fällung und die Trocknung der PBO-Vorstufe erfolgt wie in Beispiel 2.

Die erhaltene PBO-Vorstufe ist in den in Beispiel 2 aufgeführten Lösemitteln gut löslich. Bei dieser Vorstufe wird eine Feuchteaufnahme von 0,86 % (siehe Beispiel 3) und ein Planarisierungsgrad von 82 % (siehe Beispiel 4) ermittelt; die Temperaturstabilität beträgt 480°C (siehe Beispiel 5). Nach der entsprechend Beispiel 6 durchgeführten Photostrukturierung und Cyclisierung auf dem Substrat werden hochtemperaturstabile Resiststrukturen mit einer Auflösung von 2 µm bei einer Schichtdicke von 2,2 µm erhalten.

### Beispiel 13

### Herstellung einer PBO-Vorstufe und Bestimmung der Eigenschaften

Analog zu Beispiel 12 wird eine PBO-Vorstufe hergestellt, wobei - unter sonst gleichen Bedingungen - als Bis-o-aminophenol 4,4'-Bis(4-amino-3-hydroxy-2,5,6-trifluor-phenoxy)-octafluorbiphenyl (0,1 mol, d.h. 65,2 g) und als Dicarbonsäure 4,4'-Bis(4-carboxy-phenoxy)-octafluorbiphenyl (0,1 mol, d.h. 57 g) eingesetzt wird. Das Bis-o-aminophenol wird - analog Beispiel 1 - aus 4,4'-Octafluorbiphenol und Pentafluor-nitrobenzol hergestellt.

Die erhaltene PBO-Vorstufe ist in den in Beispiel 2 aufgeführten Lösemitteln gut löslich. Bei dieser Vorstufe wird eine Feuchteaufnahme von 0,72 % (siehe Beispiel 3) und ein Planarisierungsgrad von 82 % (siehe Beispiel 4) ermittelt. Nach der entsprechend Beispiel 6 durchgeführten Photostrukturierung und Cyclisierung auf dem Substrat werden hochtemperaturstabile Resiststrukturen mit einer Auflösung von 2 µm bei einer Schichtdicke von 1,8 µm erhalten.

### Beispiel 14

### Herstellung einer PBO-Vorstufe und Bestimmung der Eigenschaften

Analog zu Beispiel 12 wird eine PBO-Vorstufe hergestellt, wobei - unter sonst gleichen Bedingungen - als Bis-o-aminophenol 2,4-Bis(4-amino-3-hydroxy-phenoxy)-3,5,6-trifluorpyridin (0,1 mol, d.h. 37,9 g) und als Dicarbonsäure 4,4'-Bis(4-carboxy-phenoxy)-octafluorbiphenyl (0,1 mol, d.h. 57 g) eingesetzt wird. Das Bis-o-aminophenol wird - analog Beispiel 1 - aus 5-Hydroxy-2-nitro-phenylbenzylether und Pentafluorpyridin hergestellt.

Die erhaltene PBO-Vorstufe ist in den in Beispiel 2 aufgeführten Lösemitteln gut löslich. Bei dieser Vorstufe wird eine Feuchteaufnahme von 0,96 % (siehe Beispiel 3) und ein Planarisierungsgrad von 84 % (siehe Beispiel 4) ermittelt. Nach der entsprechend Beispiel 6 durchgeführten Photostrukturierung und Cyclisierung auf dem Substrat werden hochtemperaturstabile Resiststrukturen mit einer Auflösung von 2 µm bei einer Schichtdicke von 2 µm erhalten.

### Beispiel 15

### Herstellung einer PBO-Vorstufe und Bestimmung der Eigenschaften

Analog zu Beispiel 12 wird eine PBO-Vorstufe hergestellt, wobei - unter sonst gleichen Bedingungen - als Bis-o-aminophenol 2,4-Bis(4-amino-3-hydroxy-phenoxy)-1-trifluormethyl-3,5,6-trifluorbenzol (0,1 mol, d.h. 44,6 g) und als Dicarbonsäuredichlorid Isophthalsäuredichlorid (0,1 mol, d.h. 20,3 g) eingesetzt wird. Das Bis-o-aminophenol wird - analog Beispiel 1 - aus 5-Hydroxy-2-nitro-phenylbenzylether und Octafluortoluol hergestellt.

Die erhaltene PBO-Vorstufe ist in den in Beispiel 2 aufgeführten Lösemitteln gut löslich. Bei dieser Vorstufe wird eine Feuchteaufnahme von 0,9 % (siehe Beispiel 3) und ein Planarisierungsgrad von 83 % (siehe Beispiel 4) ermittelt. Nach der entsprechend Beispiel 6 durchgeführten Photostrukturierung und Cyclisierung auf dem Substrat werden hochtemperaturstabile Resiststrukturen mit einer Auflösung von 2 µm bei einer Schichtdicke von 2 µm erhalten.

## Patentansprüche

1. Polybenzoxazol- und Polybenzothiazol-Vorstufen, ge **kennzeichnet durch** folgende Partialstruktur: 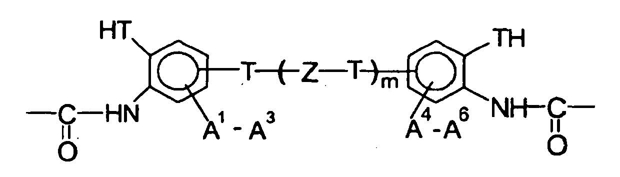 wobei folgendes gilt:
A¹ bis A⁶ sind - unabhängig voneinander - H, F, CH₃, CF₃, OCH₃, OCF₃, CH₂CH₃, CF₂CF₃, OCH₂CH₃ oder OCF₂CF₃;
T ist O oder S, und m ist 0 oder 1;
Z ist einer der folgenden Reste: 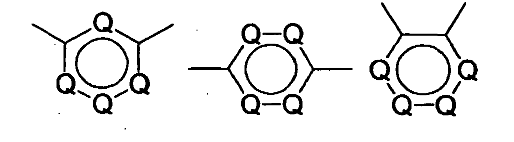 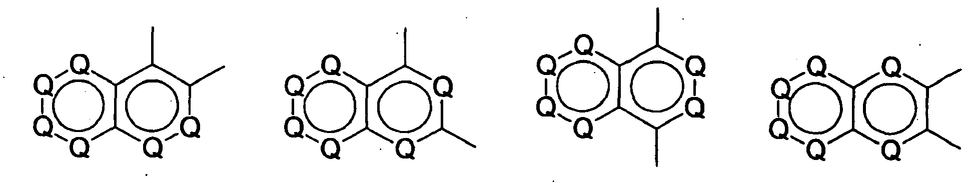 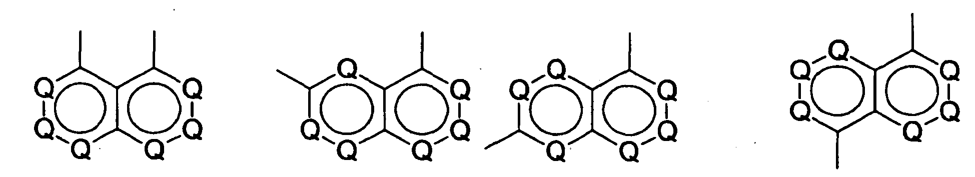 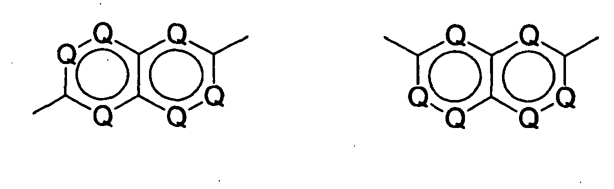 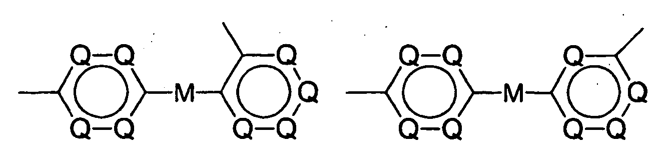 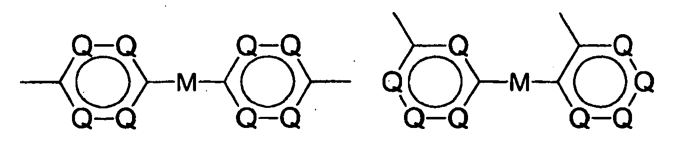 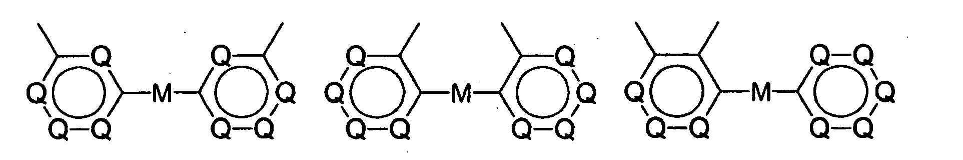 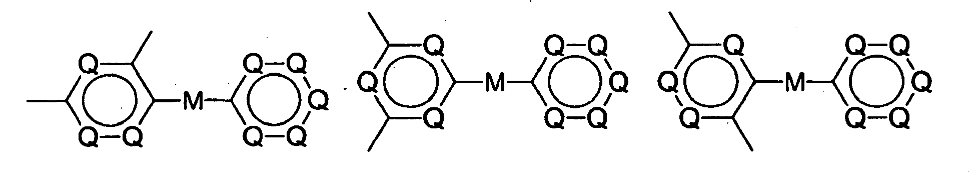 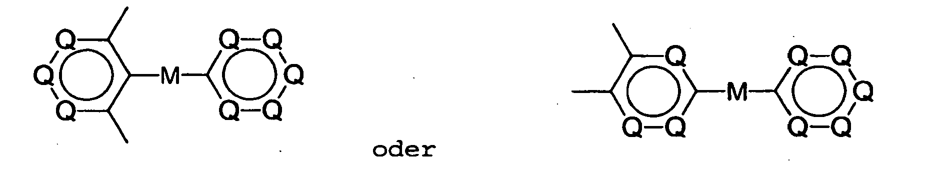
mit
Q = C-A oder N,
mit A = H, F, (CH₂)ₚCH₃, (CF₂)ₚCF₃, O(CH₂)ₚCH₃, O(CF₂)ₚCF₃, CO(CH₂)ₚCH₃, CO(CF₂)ₚCF₃ mit p = 0 bis 8 (Kette linear oder verzweigt), OC(CH₃)₃, OC(CF₃)₃, C₆H₅, C₆F₅, OC₆H₅, OC₆F₅, Cyclopentyl, Perfluorcyclopentyl, Cyclohexyl oder Perfluorcyclohexyl,
wobei in den isolierten aromatischen Ringen maximal 3 N-Atome pro Ring vorhanden sein dürfen und nur 2 N-Atome benachbart sein können und in den anellierten Ringsystemen maximal 2 N-Atome pro Ring vorhanden sein dürfen,
M = eine Einfachbindung, geradkettige Alkylen-Gruppe, CH(CH₃), CH(CF₃), CF(CH₃), CH(C₆H₅), CH(C₆F₅), CF(C₆H₅), CF(C₆F₅), C(CH₃)(C₆H₅), C(CH₃)(C₆F₅), C(CF₃)(C₆H₅), C(CF₃) (C₆F₅), C(C₆H₅)₂, C(C₆F₅)₂, CO, SO₂, 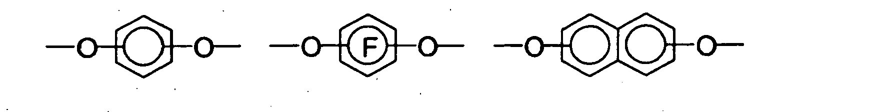 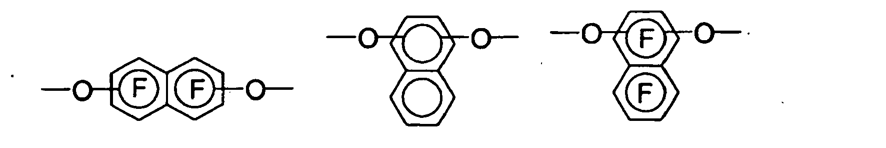 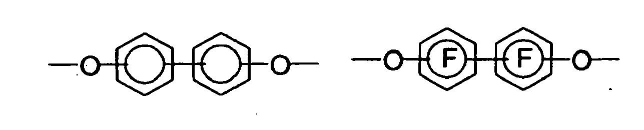 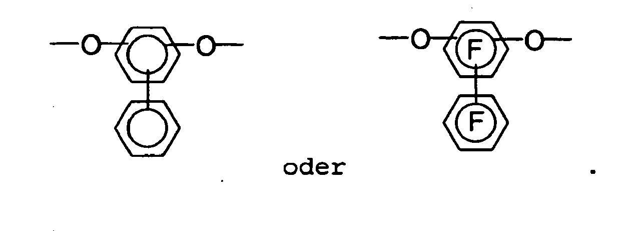
mit der Maßgabe, daß bei Z = Phenylen oder m = 0 mindestens einer der Reste A¹ bis A⁶ ≠ H sein muß und bei Z = 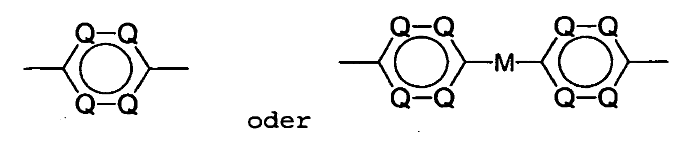 wenn Q die Bedeutung C-F hat und M eine Einfachbindung ist, sich die NH-CO-Gruppierungen der Polybenzoxazol-Partialstruktur in o- oder p-Stellung zur O-Brücke befinden müssen.

2. Photoresistlösungen, **dadurch gekennzeichnet, daß** sie eine Polybenzoxazol- oder Polybenzothiazol-Vorstufe nach Anspruch 1 und ein Diazoketon als photoaktive Komponente, gelöst in einem organischen Lösemittel, enthalten.

3. Photoresistlösungen nach Anspruch 2, **dadurch gekennzeichnet, daß** das Gewichtsverhältnis von Polybenzoxazol- bzw. Polybenzothiazol-Vorstufe zu Diazochinon als Diazoketon zwischen 1:20 und 20:1 liegt, vorzugsweise zwischen 1:10 und 10:1.

## Claims

1. Polybenzoxazole precursors and polybenzothiazole precursors **characterized by** the following partial structure: 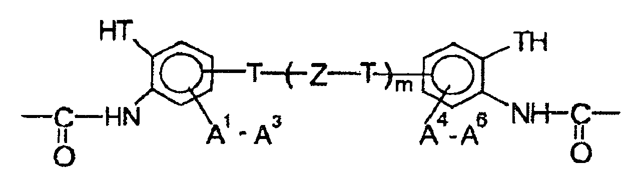 where:
A¹ to A⁶ are - independently of one another - H, F, CH₃, CF₃, OCH₃, OCF₃, CH₂CH₃, CF₂CF₃, OCH₂CH₃ or OCF₂CF₃;
T is O or S, and m is 0 or 1;
Z is one of the following radicals: 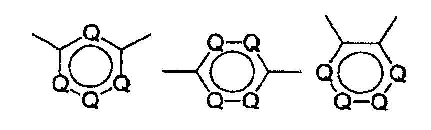 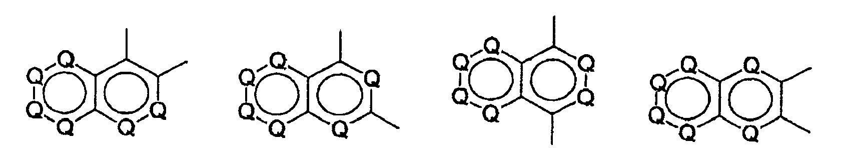 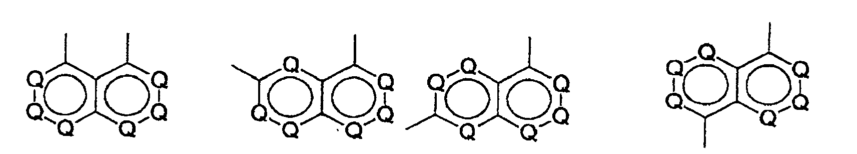 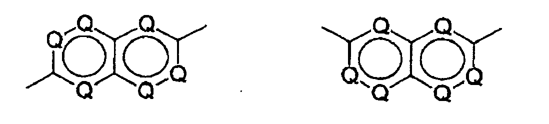 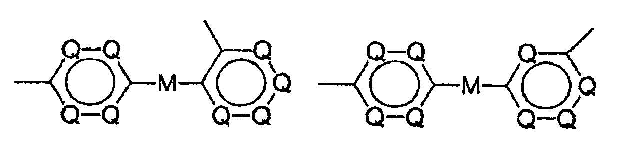 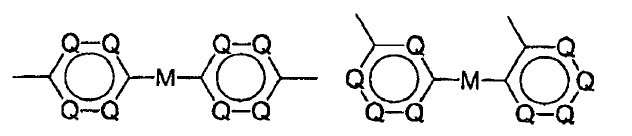 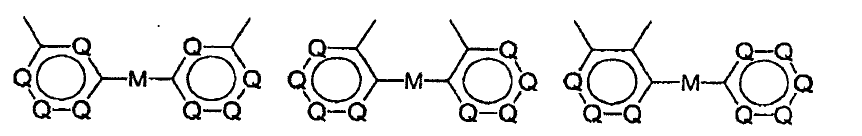 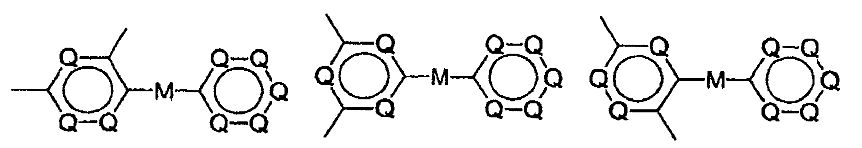 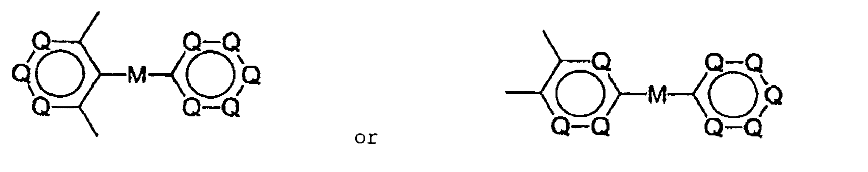
where
Q = C-A or N,
where A = H, F, (CH₂)ₚCH₃, (CF₂)ₚCF₃, O(CH₂)ₚCH₃, O(CF₂)ₚCF₃, CO(CH₂)ₚCH₃, CO(CF₂)ₚCF₃, where p = 0 to 8 (linear or branched chain), OC(CH₃)₃, OC(CF₃)₃, C₆H₅, C₆F₅, OC₆H₅, OC₆F₅, cyclopentyl, perfluorocyclopentyl, cyclohexyl or perfluorocyclohexyl,
wherein, in the isolated aromatic rings, a maximum of 3 N atoms may be present per ring and only 2 N atoms may be adjacent, and, in the fused ring systems, a maximum of 2 N atoms may be present per ring,
M= a single bond, straight-chain alkylene group, CH(CH₃), CH(CF₃), CF(CH₃), CH (C₆H₅), CH (C₆F₅), CF(C₆H₅), CF(C₆F₅), C(CH₃)(C₆H₅), C(CH₃)(C₆F₅). C(CF₃)(C₆H₅), C(CF₃)(C₆F₅), C(C₆H₅)₂, C(C₆F₅)₂, CO, SO₂, 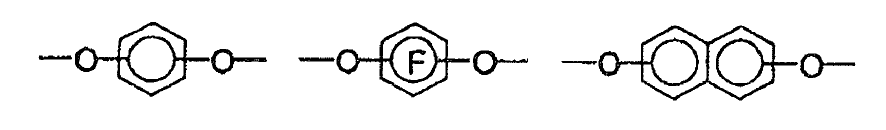 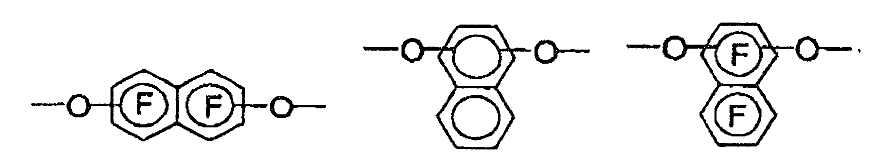 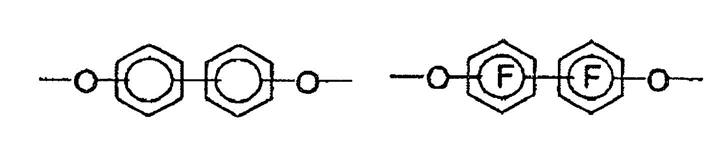 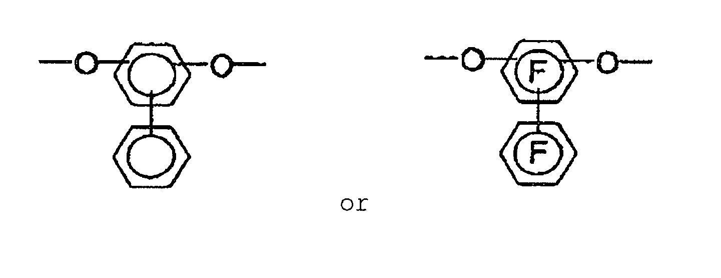
with the proviso that, when Z = phenylene or m = 0, at least one of the radicals A¹ to A⁶ must be other than H, and when
Z = 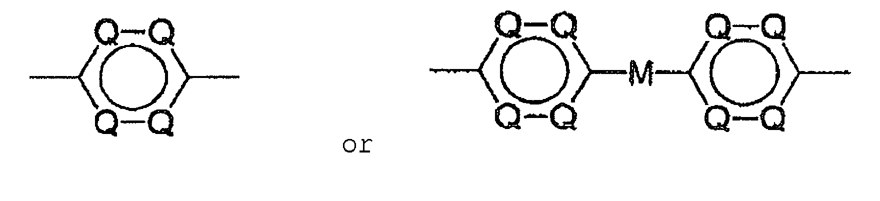 where Q is C-F and M is a single bond, the NH-CO groups of the polybenzoxazole partial structure must be in the o- or p-position to the O bridge.

2. Photoresist solutions **characterized in that** they contain a polybenzoxazole precursor or a polybenzothiazole precursor according to Claim 1 and a diazoketone as photoactive component, dissolved in an organic solvent.

3. Photoresist solutions according to Claim 2, **characterized in that** the weight ratio between the polybenzoxazole precursor or the polybenzothiazole precursor and the diazoquinone as diazoketone is between 1:20 and 20:1, preferably between 1:10 and 10:1.

## Revendications

1. Précurseurs de polybenzoxazol et de polybenzothiazol, **caractérisé par** une structure partielle suivante : 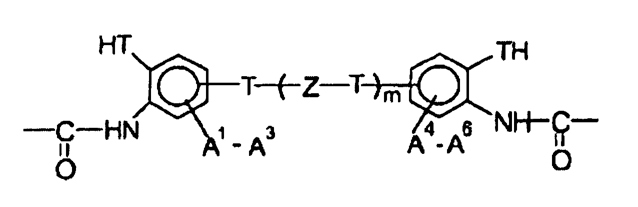 dans laquelle on a ce qui suit :
A¹ à A⁶ sont, indépendamment l'un de l'autre, H, F, CH₃, CF₃, OCH₃, OCF₃, CH₂CH₃, CF₂CF₃, OCH₂CH₃ ou OCF₂CF₃ ;
T est O ou S, et m est 0 ou 1 ;
Z est l'un des radicaux suivants : 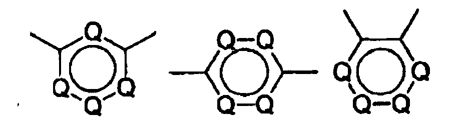 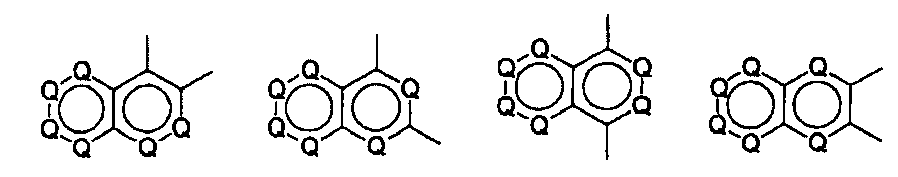 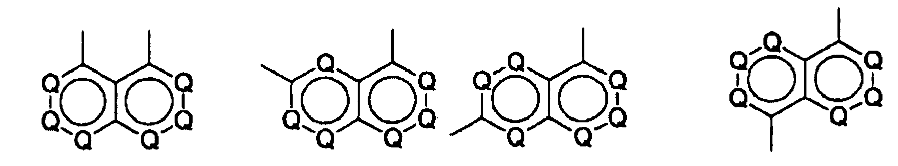 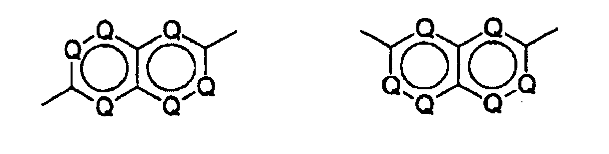 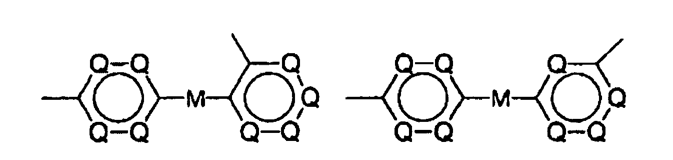 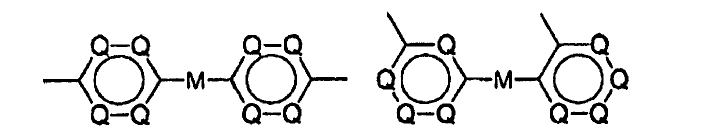 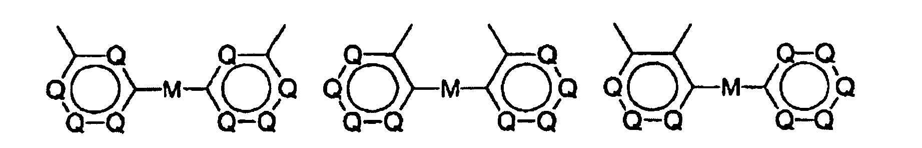 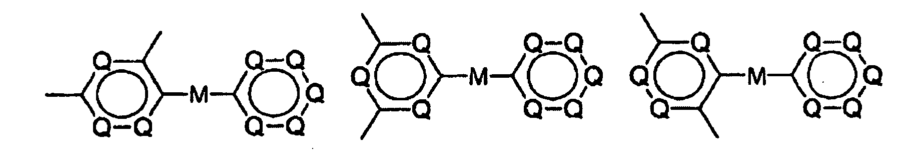 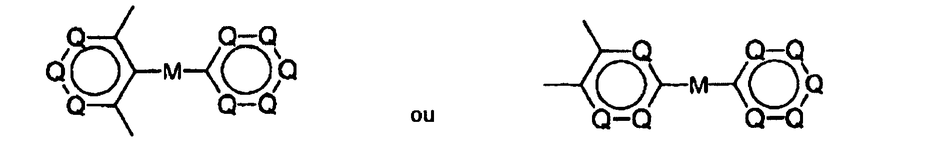 avec
Q = C-A ou N,
avec A = H, F, (CH₂)ₚCH₃, (CF₂)ₚCF₃, O(CH₂)ₚCH₃, O(CF₂)ₚCF₃, CO(CH₂)ₚCH₃, CO(CF₂)ₚCF₃ avec p = 0 à 8 (chaîne linéaire ou ramifiée), OC(CH₃)₃, OC(CF₃)₃, C₆H₅, C₆F₅, OC₆H₅, OC₆F₅, cyclopentyle, perfluorocyclopentyle, cyclohexyle ou perfluorocyclohexyle,
dans lequel, dans les cycles aromatiques isolés, il peut y avoir au maximum 3 atomes de N par cycle et seulement 2 atomes de N peuvent être voisins, et dans les systèmes cycliques annelés, il peut y avoir au maximum 2 atomes de N par cycle,
M = une simple liaison, un groupe alcoylène en chaîne linéaire, CH (CH₃), CH (CF₃), CF (CH₃), CH(C₆H₅), CH (C₆F₅), CF(C₆H₅), CF(C₆F₅), C (CH₃) (C₆H₅), C (CH₃) (C₆F₅), C (CF₃) (C₆H₅), C (CF₃) (C₆F₅), C (C₆H₅) ₂, C(C₆F₅)₂, CO, SO₂, 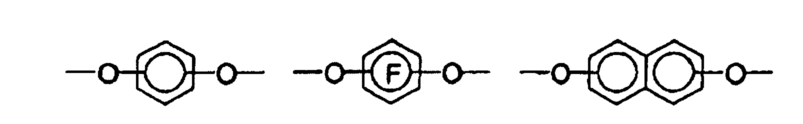 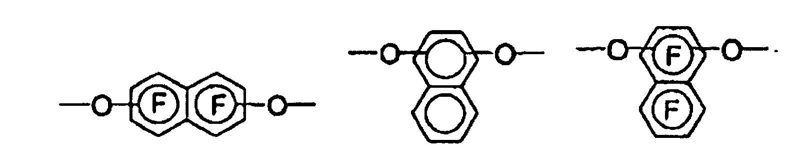 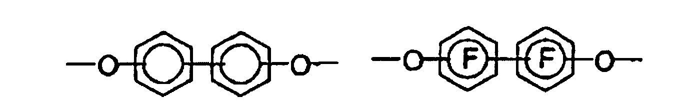 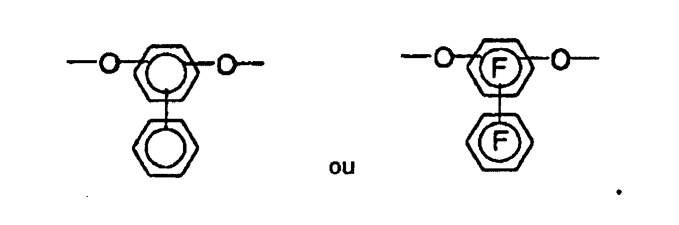
avec la condition que, lorsque Z = phénylène ou m = 0, au moins l'un des radicaux A¹ à A⁶ doit être différent de H et, lorsque Z = 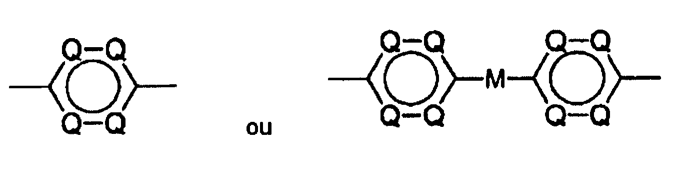
ou lorsque Q a la signification C-F et M est une liaison simple, les groupements NH-CO de la structure partielle de polybenzoxazol doivent se trouver en position ortho ou en position para par rapport au pont O.

2. Solutions de réserve photosensible, **caractérisées en ce qu'**elles contiennent un précurseur de polybenzoxazol ou de polybenzothiazol suivant la revendication 1 et une diazocétone comme constituant photoactif, dissous dans un solvant organique.

3. Solutions de réserve photosensible suivant la revendication 2, **caractérisées en ce que** le rapport en poids du précurseur de polybenzoxazol ou de polybenzothiazol à la diazoquinone en tant que diazocétone est compris entre 1:20 et 20:1, et de préférence entre 1:10 et 10:1.
